# EUROPÄISCHE PATENTSCHRIFT

(11) **EP 1 660 848 B1**
(45) Veröffentlichungstag und Bekanntmachung des Hinweises auf die Patenterteilung: **04.05.2011**
(21) Anmeldenummer: 04715878.7
(22) Anmeldetag: 01.03.2004
(51) Int. Cl.: G01J 3/26, G02B 26/00, C23C 14/00

(54) **VERFAHREN ZUM AUFBRINGEN EINES FILTERS AUF EINER FOLIE**
METHOD FOR APPLICATION OF A FILTER ON A FOIL
PROCEDE POUR APPLIQUER UN FILTRE SUR UN FILM

(43) Veröffentlichungstag der Anmeldung: 31.05.2006
(73) Patentinhaber: Applied Materials GmbH & Co. KG, 63755 Alzenau (DE)
(72) Erfinder: HOFFMANN, Gerd, 63486 Bruchköbel (DE); LUDWIG, Rainer, 63768 Hösbach (DE); LOTZ, Hans-Georg, 63584 Gründau-Rothenbergen (DE); STEINIGER, Gerhard, 63549 Ronneburg (DE)
(74) Vertreter: Schickedanz, Willi
(86) Internationale Anmeldenummer: PCT/DE2004/000392
(87) Internationale Veröffentlichungsnummer: WO 2005/085780

(56) Entgegenhaltungen:
- EP-A- 0 860 513
- DE-A- 19 834 734
- DE-C- 19 845 268
- US-A- 2 590 906
- US-A- 3 011 383
- US-A- 5 182 670
- US-A- 5 218 472
- US-A1- 2002 197 459

## Beschreibung

Die Erfindung betrifft ein Verfahren zum Aufbringen eines Filters auf einer Folie nach den Merkmalen des Patentanpruchs 1.

Übliche Vakuumbeschichtungsanlagen sind lediglich in der Lage, in einem Durchlauf des Substrats nur jeweils eine Schicht aus einem bestimmten Material aufzubringen. Besteht eine Beschichtung aus mehreren Schichten, so sind mehrere Durchläufe notwendig, was zur Folge hat, dass für jeden Durchlauf die Anlage neu beschickt und evakuiert werden muss. Die hierfür benötigte Zeit und der entsprechende Personalaufwand vermindern die Produktivität und erhöhen die Produktionskosten.

Man könnte sich zwar vorstellen, in einer Vakuumbeschichtungsanlage mehrere Beschichtungsstationen unterzubringen, in denen das Substrat sukzessive mit unterschiedlichen Schichten versehen wird. Dieser Weg ist in der Regel aber nicht gangbar, weil damit erhebliche zusätzliche Investitionskosten verbunden sind.

Aus der gattungsgemäßen DE 198 34 734 A1 wird die lichtundurchlässige Schicht von einer Schmelzschicht gebildet, die aus einem Metall oder einer Metalllegierung, vorzugsweise aus Zinn oder Blei besteht. Die teildurchlässige Schicht wird vorzugsweise aus Aluminium hergestellt. Auch bei der Beschichtung, die die DE 198 34 734 A1 lehrt, ist eine Beschichtung an wenigstens zwei Stationen notwendig.

Bekannt ist ein optischer Filter, der aus einer lichtundurchlässigen metallischen Schicht besteht, die auf einem Glassubstrat aufgebracht ist (US 2,590,906). Auf dieser metallischen Schicht ist eine lichtdurchlässige Schicht angeordnet, auf der wiederum eine semitransparente Schicht angeordnet ist. Das Aufbringen eines Filters auf einer Folie ist dort allerdings nicht beschrieben.

Schließlich ist ein Verfahren zum Bedampfen bandförmiger Substrate mit einer transparenten Barriereschicht aus Aluminiumoxid durch reaktives Verdampfen von Aluminium und Einsatz von Reaktivgas in einer Bedampfungsanlage bekannt (DE 198 45 268 C1).

Das Anbringen einer transparenten Schicht zwischen zwei metallischen Schichten ist dort nicht beschrieben.

Die Erfindung beruht auf dem Problem, ein Verfahren bereitzustellen, mit dem ein Filter auf eine Folie aufgebracht werden kann, wobei der Filter ähnliche Farbeffekte aufweist wie bisher bekannte Beschichtungen und wobei der Filter so beschaffen ist, dass er mit üblichen Produktionsanlagen realisiert werden kann.

Dieses Problem wird nach den Merkmalen des Patentanspruches 1 gelöst.

Zur Lösung dieses Problems sieht die Erfindung dabei ein Verfahren zum Aufbringen eines Filters auf eine Folie vor, das die folgenden Schritte aufweist:
- Bereitstellen einer Vakuumbeschichtungsanlage mit einer Verdampfungseinrichtung in einer evakuierbaren Vakuumkammer und einer Materialzuführeinrichtung, wobei die VaKuumkammer eine erste und eine zweite Vorratsrolle aufweist:
- Beschicken der Verdampfungseinrichtung mit einem Metall:
- Schließen der Vakuumkammer und Erzeugen eines Vakuums darin:
- Ausschließliches Verdampfen des Metalls in einem ersten Durchgang, wobei die Folie von der ersten Vorratsrolle abgewickelt und auf die zweite Vorratsrolle aufgewickelt wird, so dass das Metall sich zu einer ersten Schicht auf der Folie niederschlägt:
- Umkehr der Folienförderrichtung:
- Verdampfen des Metalls bei gleichzeitigem Einbringen eines weiteren Materials in die Vakuumkammer, so dass die mit der ersten Schicht versehene Folie mit einer Zwischenschicht aus dem Metall und dem weiteren Material reaktiv bedampft wird:
- erneutes Umkehren der Folienförderrichtung:
- Ausschließliches Verdampfen des Metalls, so dass es sich zu einer zweiten reflektierenden Schicht auf der Zwischenschicht niederschlägt, wobei die Folie zum Aufdampfen einer Schicht oder Zwischenschicht von der einen Vorratsrolle (30, 31) abgewickelt und auf die andere (31, 30) aufgewickelt wird und zum Aufdampfen einer der Schicht oder Zwischenschicht folgenden Schicht zurückgewickelt wird: - Öffnen der Beschichtungskammer und Entnahme der beschichteten Folie.

Wie man den Verfahrensschritten entnehmen kann, ist eine Vakuumbeschichtungsanlage mit nur einer einzigen Verdampfungseinrichtung in der Lage, die Beschichtung in einem Evakuierungszyklus durchzuführen. Die Anlage muss nur einmal evakuiert werden. Vorteilhaft ist dabei, dass die Folienförderrichtung umgekehrt wird. Erst nachdem der aus drei Schichten bestehende Fabry-Perot-Filter vollständig aufgebaut ist, wird die Beschichtungsanlage wieder geöffnet und das beschichtete Substrat entnommen.

Da, wie oben schon ausgeführt, als weiteres Material ein Gas, insbesondere ein Sauerstoff, zugeführt wird, besteht die Materialzuführeinrichtung aus einem Gasanschluss mit einer Lanzette, mit der das Gas in den Bereich der Verdampfungswolke geleitet wird.

Zum Beschichten von Folien weist die Beschichtungsanlage eine gekühlte Beschichtungswalze auf, auf der die Folie abgerollt wird und dabei von der unter der Verdampfungs-Beschichtungswalze angeordneten Verdampfungseinrichtung beschichtet wird. Des Weiteren weist die Vakuumkammer zwei Vorratsrollen auf, wobei die Folie zunächst von der ersten Vorratsrolle abgewickelt und auf die zweite Vorratsrolle aufgewickelt wird. Zum Aufbringen der Zwischenschicht vertauschen die beiden Rollen ihre Funktion. Die im ersten Durchgang aufgewickelte Rolle wird wieder abgewickelt, so dass sich die erste Rolle wieder füllt. In einem dritten Durchgang wird die zweite Reflektionsschicht aufgebracht, wobei die Folie wieder von der ersten Rolle abgewickelt und auf die zweite Rolle aufgewickelt wird.

Wie sich aus den Erläuterungen ergibt, brauchen daher bekannte einfache Beschichtungsanlagen nicht wesentlich geändert zu werden. Es muss lediglich dafür gesorgt werden, dass zusätzlich vorgesehene Führungsrollen zum Zuführen der Folie zu den Vorratsrollen so angeordnet und eingesetzt werden, dass das System sowohl in der einen als auch in der anderen Richtung von der Folie durchlaufen werden kann.

Es wird somit ein Filter erhalten, bei dem die reflektierenden Schichten aus demselben Grundmaterial bestehen und die Zwischenschicht aus einer chemischen Verbindung dieses Grundmaterials mit einem weiteren Material.

Ein solcher Schichtaufbau hat, wie Versuche mit Aluminium als Grundmaterial und Sauerstoff als weiteres Material dargelegt haben, gezeigt, dass die entstehenden Filter ähnliche Farbeffekte hervorrufen wie die Fabry-Perot-Schichten gemäß dem oben zitierten Stand der Technik. Sie lassen sich aber wesentlich einfacher und mit einfacheren Mitteln auf ein Substrat aufbringen. Die Verdampfungsanlage einer Beschichtungsanlage braucht lediglich mit einem Grundmaterial bestückt zu werden, wobei durch dessen Verdampfung die beiden Reflektionsschichten gebildet werden. Zur Bildung der Zwischenschicht wird dem Metalldampf das weitere Material zugeführt, so dass es sich mit dem Grundmaterial auf der ersten reflektierenden Schicht niederschlagen kann.

Üblicherweise handelt es sich bei dem Grundmaterial um ein Metall und bei dem weiteren Material um Sauerstoff, der über entsprechende Zuleitungen in die evakuierte Verdampfungskammer eingeleitet werden kann. Die dazu notwendigen Systeme und Vorgehensweisen sind bekannt. Durch die Zuführung von Sauerstoff entsteht eine so genannte reaktive Beschichtung, weil sich der Sauerstoff zum Teil mit den Metallatomen oder -ionen bzw. Molekülen in der Metallverdampfungswolke chemisch verbindet, zum Teil mit dieser auf dem Substrat niedergeschlagen wird und erst dort eine Verbindung mit dem Metall eingeht. Die Reaktionen laufen dabei aber nicht vollständig, so dass gewolltermaßen Beschichtungen entstehen, die nicht unbedingt eine stöchiometrische Verteilung der beteiligten Reaktionspartner aufweisen.

Besonders einfach lässt sich Aluminium als Grundmaterial verarbeiten, so dass die Zwischenschicht aus einem Aluminiumoxid mit der Strukturformel Al₂O₃ besteht.

Statt Sauerstoff kann auch Stickstoff verwendet werden, so dass als Zwischenschicht eine Metall-Stickstoff-Verbindung vorliegt, bzw. Aluminiumnitrid, wenn es sich bei dem Metall um Aluminium handelt.

In einigen Fällen, z. B. insbesondere dann, wenn es sich bei dem Substrat um Folien bzw. Verpackungsfolien handelt, soll das Filtermaterial insgesamt lichtundurchlässig sein. Dies wird dadurch erreicht, dass die an das Substrat anschließende, erste reflektierende Schicht lichtundurchlässig ist und die außen liegende, zweite reflektierende Schicht teildurchlässig ist. Erreicht wird dies durch entsprechende Dicken der jeweiligen Schichten. Werte, die hierfür in Frage kommen, liegen für die erste reflektierende Schicht zwischen 50 und 200 nm und für die zweite reflektierende Schicht zwischen 1 bis 20 nm, wobei die Zwischenschicht je nach gewünschter Eigenschaft des Filters zwischen 50 bis 2.000 nm dick ist.

Im Folgenden soll daher anhand eines Ausführungsbeispiels die Erfindung näher erläutert werden. Dazu zeigt:
- Fig. 1: einen typischen Aufbau eine Fabry-Perot-Filters auf einem Substrat,
- Fig. 2: ein Diagramm mit den Reflektionseigen- schaften des Filters bezogen auf verschie- dene Wellenlängen sowie in Abhängigkeit von der Dicke d der Zwischenschicht,
- Fig. 3: eine schematische Darstellung einer Vaku- umbeschichtungsanlage.

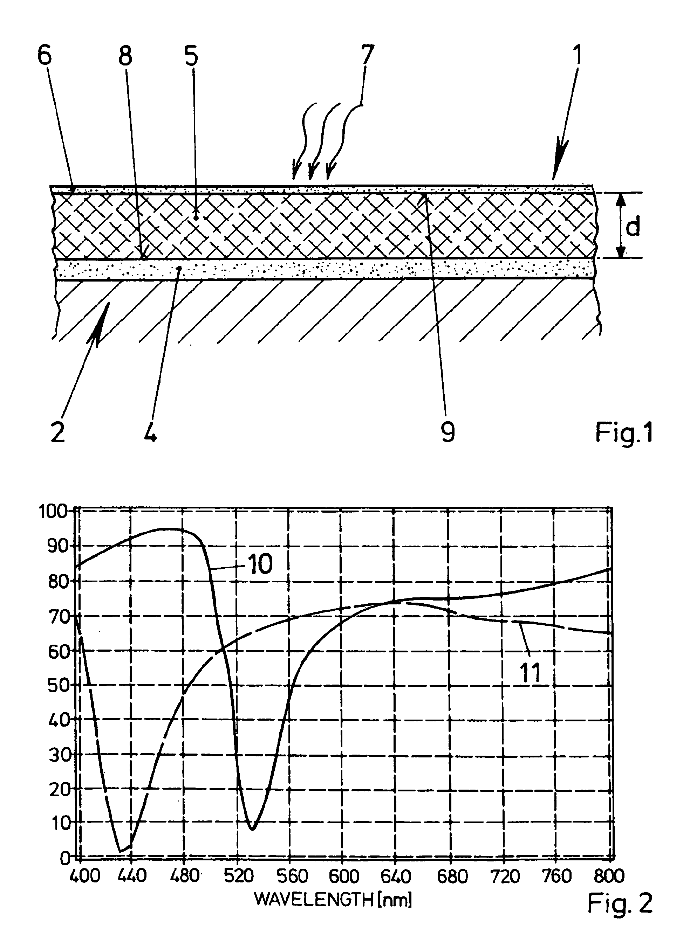

Zunächst wird auf die Figur 1 Bezug genommen. Diese zeigt im Querschnitt einen Fabry-Perot-Filter 1 auf einem Substrat 2. Der Filter 1 besteht aus drei Schichten, nämlich einer ersten Reflektionsschicht 4 aus Aluminium, einer darauf aufgebrachten Zwischenschicht 5 der Dicke d aus Aluminiumoxid Al₂O₃, sowie eine darauf aufgebrachte zweite Reflektionsschicht 6 ebenfalls aus Aluminium. Wie man erkennt, ist die erste Reflektionsschicht 4 deutlich dicker als die zweite Reflektionsschicht 6. Die erste Reflektionsschicht 4 ist daher lichtundurchlässig, während die zweite außenliegende Schicht 6 teildurchlässig ist.

Licht 7, das in den Filter 1 eindringt, wird zwischen den reflektierenden Flächen 8, 9 der reflektierenden Schichten 4, 6 hin- und hergeworfen, wobei Licht mit einer Wellenlänge, das der Dicke d der Zwischenschicht 5 entspricht, durch Interferenz zum Teil absorbiert wird. Dadurch ergeben sich die in dem Diagramm der Figur 2 dargestellten Spektren 10, 11.

Auf der X-Achse des Diagramms sind die Wellenlängen zwischen 400 und 800 nm abgetragen, auf der Y-Achse die Reflektanz des Filters in Prozent. Den beiden Spektren 10, 11 liegt jeweils ein Filter zugrunde, bei dem die erste reflektierende Schicht 4 eine Dicke von 100 nm und die zweite reflektierende Schicht 6 eine Dicke von 10 nm aufweist. Für das eine Spektrum 10 (dicke Kurve) beträgt die Dicke der Zwischenschicht 200 nm, so dass Wellenlängen im Bereich von 530 nm stark absorbiert, d. h. nicht reflektiert werden. Für eine Dicke von 62,5 nm der Zwischenschicht ergibt sich das andere Spektrum 11 (dünne Kurve) mit einem Reflektionsminimum für Wellenlängen um 430 nm.

Eine Schicht gemäß dem einen Spektrum 10 weist somit eine reduzierte Reflektion im grünen Bereich auf, so dass sich ein deutlich purpurfarbener Reflex ergibt. Für das andere Spektrum 11 ergibt sich ein gelblich-grüner Farbreflex.

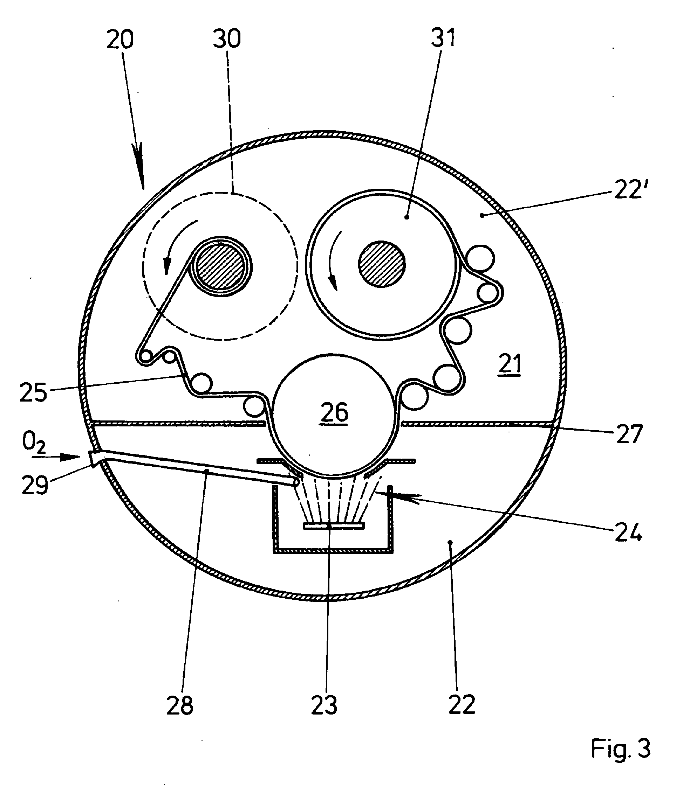

Die Beschichtung wird mit mittels einer Beschichtungsanlage auf eine Folie aufgebracht, wie dies in der Figur 3 schematisch gezeigt ist.

Die Anlage 20 besteht aus einer zweigeteilten Vakuumkammer 21 mit einer unteren und einer oberen Vakuumkammer 22, 22', wobei in der unteren Kammer 22 eine Verdampfungseinrichtung 23 angeordnet ist. Hierbei kann es sich z. B. um einen Tiegel handeln, der das zu verdampfende Material aufnimmt, das in dem Tiegel mittels hier nicht näher dargestellter Elektronenkanonen verdampft wird. Der Dampf 24 trifft auf eine Folie 25, die über eine gekühlte Beschichtungswalze 26, die sich in einer Öffnung in einer Trennwand 27 zwischen den beiden Vakuumkammern 22, 22' befindet, abgerollt wird. In der unteren Vakuumkammer 22 befindet sich zusätzlich eine Lanzette 28, über die über einen Außenanschluss 29 ein Gas, z. B. Sauerstoff, in die Verdampfungswolke 24 geleitet werden kann. In der oberen zweiten Vakuumkammer 22' befindet sich eine erste Vorratsrolle 30 und eine zweite Vorratsrolle 31. In einem ersten Durchgang wird die erste Vorratsrolle 30 abgewickelt und die Folie auf die zweite Vorratsrolle 31 aufgewickelt. Dabei wird das im Tiegel verdampfende Material, also z. B. Aluminium, auf die Folie aufgebracht. Die Schichtdicke wird dabei vor allem durch die Transportgeschwindigkeit der Folie bestimmt. In einem zweiten Durchlauf wird der Wickelvorgang umgekehrt. Die Folie 25 wird von der zweiten Vorratsrolle 31 abgewickelt und wieder zurück auf die erste Vorratsrolle 30 gebracht. Bei diesem zweiten Durchlauf wird Sauerstoff über die Lanzette 28 in die Verdampfungswolke 24 eingebracht. Dabei kann der Verdampfungswolke 24 noch ein Mikrowellenfeld überlagert werden. Der Sauerstoff verbindet sich mit den verdampften Metallatomen und schlägt sich mit diesen auf die erste Reflektionsschicht 4 als Zwischenschicht 5 nieder. Die chemische Verbindung zu Aluminiumoxid tritt zum Teil erst dann ein, wenn beide Materialien als Schicht niedergeschlagen sind. Dieser Vorgang wird auch als reaktives Beschichten bezeichnet.

Im dritten Durchgang wird die Transportrichtung der Vorratsrollen 30, 31 wieder umgekehrt und durch ausschließliches Verdampfen des Metalls die zweite reflektierende Schicht aufgebracht.

### Bezugszeichenliste

- 1: Fabry-Perot-Filter
- 2: Substrat
3
- 4: erste Reflektionsschicht
- 5: Zwischenschicht
- 6: zweite Reflektionsschicht
- 7: Licht
- 8, 9: Flächen
- 10, 11: Spektren
12
13
14
15
16
17
18
19
- 20: Anlage
- 21: Vakuumkammer
- 22: untere Kammer
- 22': obere Kammer
- 23: Verdampfungseinrichtung
- 24: Verdampfungswolke
- 25: Folie
- 26: Beschichtungswalze
- 27: Trennwand
- 28: Lanzette
- 29: Außenanschluss
- 30: erste Vorratsrolle
- 31: zweite Vorratsrolle

## Patentansprüche

1. Verfahren zum Aufbringen eines Filters auf eine Folie, **gekennzeichnet durch** folgende Schritte:
- Bereitstellen einer Vakuumbeschichtungsanlage mit einer Verdampfungseinrichtung in einer evakuierbaren Vakuumkammer und einer Materialzuführeinrichtung, wobei die Vakuumkammer eine erste und eine zweite Vorratsrolle aufweist;
- Beschicken der Verdampfungseinrichtung mit einem Metall;
- Schließen der Vakuumkammer und Erzeugen eines Vakuums darin;
- Ausschließliches Verdampfen des Metalls in einem ersten Durchgang, wobei die Folie von der ersten Vorratsrolle abgewickelt und auf die zweite Vorratsrolle aufgewickelt wird, so dass das Metall sich zu einer ersten Schicht auf der Folie niederschlägt;
- Umkehr der Folienförderrichtung;
- Verdampfen des Metalls bei gleichzeitigem Einbringen eines weiteren Materials in die Vakuumkammer, so dass die mit der ersten Schicht versehene Folie mit einer Zwischenschicht aus dem Metall und dem weiteren Material reaktiv bedampft wird;
- erneutes Umkehren der Folienförderrichtung;
- Ausschließliches Verdampfen des Metalls, so dass es sich zu einer zweiten reflektierenden Schicht auf der Zwischenschicht niederschlägt, wobei die Folie zum Aufdampfen einer Schicht oder Zwischenschicht von der einen Vorratsrolle (30, 31) abgewickelt und auf die andere (31, 30) aufgewickelt wird und zum Aufdampfen einer der Schicht oder Zwischenschicht folgenden Schicht zurückgewickelt wird;
- Öffnen der Beschichtungskammer und Entnahme der beschichteten Folie.

2. Verfahren nach Anspruch 1, **dadurch gekennzeichnet, dass** es sich bei der Materialzuführeinrichtung um einen Gasanschluss handelt.

## Claims

1. A method for the application of a filter on a web, **characterized by** the following steps:
- providing a vacuum coating facility with a vaporization device in an evacuatable vacuum chamber and a material supply device, wherein the vacuum chamber includes a first stock roll and a second stock roll;
- charging the vaporization device with a metal;
- closing the vacuum chamber and generating a vacuum therein;
- vaporizing the metal exclusively in a first pass, wherein the web, which is provided on the first stock roll, is being wound from said first stock roll and wound onto the second stock roll, such that the metal is deposited as a first layer on the web;
- reversing the transport direction of the web;
- vaporizing the metal with the simultaneous introduction of a further material into the vacuum chamber, such that the web provided with the first layer is reactively vapor-deposited with an intermediate layer of the metal and the further material;
- reversing the transport direction of the web again;
- vaporizing the metal exclusively, such that it is deposited on the intermediate layer to form a second reflecting layer, wherein the web for the evaporation of a layer or intermediate layer is being wound from the one stock roll (30, 31) and wound onto the other stock roll (31, 30) and, for the evaporation of a layer being subsequent to one of the layer or intermediate layer, is being rewound;
- opening the coating chamber and removing the coated web.

2. The method as claimed in claim 1, wherein the material supply device is a gas connection.

## Revendications

1. Procédé permettant d'appliquer un filtre sur un film, **caractérisé par** les étapes suivantes:
- la mise à disposition d'une installation de revêtement sous vide équipé d'un dispositif d'évaporation situé dans une chambre à vide pouvant être mise sous vide, et d'un dispositif d'amenée de matière, la chambre à vide présentant un premier et un deuxième rouleau d'alimentation;
- l'alimentation du dispositif d'évaporation avec un métal;
- la fermeture de la chambre à vide et la génération d'un vide à l'intérieur de celle-ci;
- l'évaporation exclusive du métal lors d'un premier passage, le film étant déroulé depuis le premier rouleau d'alimentation et enroulé sur le deuxième rouleau d'alimentation de sorte que le métal se dépose sur le film pour former une première couche;
- l'inversion du sens de déroulement du film;
- l'évaporation du métal avec introduction simultanée d'une autre matière dans la chambre à vide de sorte que le film pourvu de la première couche est métallisé sous vide de manière réactive pour former une couche intermédiaire constituée par le métal et l'autre matière;
- la réinversion du sens de déroulement du film;
- l'évaporation exclusive du métal de sorte qu'il se dépose sur la couche intermédiaire pour former une deuxième couche réfléchissante, le film étant déroulé depuis l'un des rouleaux d'alimentation (30, 31) et enroulé sur l'autre (31, 30) pour former par vaporisation sous vide une couche ou couche intermédiaire, puis étant déroulé en sens inverse pour former par vaporisation sous vide une couche succédant à la couche ou couche intermédiaire;
- l'ouverture de la chambre de revêtement et la sortie du film revêtu.

2. Procédé selon la revendication 1, **caractérisé en ce que** le dispositif d'amenée de matière est un conduit de raccordement pour un gaz.
